# EUROPEAN PATENT APPLICATION

(11) **EP 4 645 311 A1**
(43) Date of publication of application: **05.11.2025**
(21) Application number: 25172701.2
(22) Date of filing: 25.04.2025
(51) Int. Cl.: G11C 5/00, G11C 7/10, G11C 11/412, G11C 11/418

(54) **MEMORY ARCHITECTURE WITH A DIGITAL IN-MEMORY COMPUTATION PROCESSING MODE AND A COLUMN MULTIPLEXING MEMORY ACCESS MODE**

(30) Priority: 30.04.2024 US 202463640283 P; 15.04.2025 US 202519179451
(71) Applicant: STMicroelectronics International N.V., 1228 Plan-les-Ouates, Geneva (CH)
(72) Inventor: RAWAT, Harsh, 121006 FARIDABAD (IN); CHAWLA, Nitin, 201304 NOIDA (IN); AYODHYAWASI, Manuj, 201305 NOIDA (IN); DHORI, Kedar Janardan, 201010 GHAZIABAD (IN); KUMAR, Promod, 201312 GREATER NOIDA (IN)
(74) Representative: Casalonga

(57) **Abstract**

A memory array includes sub-arrays with memory cells arranged in a row-column matrix where each row includes a word line and each sub-array column includes a local bit line. A control circuit supports: a first mode where only one word line in the memory array is actuated during a column multiplexed memory access operation; and a second mode where one word line per sub-array is simultaneously actuated during an in-memory computation operation. An input/output circuit for each column includes inputs to the local bit lines of the sub-arrays, a column data output coupled to the bit line inputs to provide data read from the array in the first mode, and a sub-array data output coupled to each bit line input to provide weight data read from the array in the second mode. A computational circuit executes the in-memory computation as a function of feature data and the read weight data.

## Description

### CROSS REFERENCE TO RELATED APPLICATIONS

This application claims priority to United States Provisional Application for Patent No. 63/640,283 filed April 30, 2024, which is incorporated herein in its entirety by reference.

### TECHNICAL FIELD

Embodiments herein relate to a memory architecture and, in particular, to memory support of both a digital in-memory computation processing mode and a column multiplexing memory access mode.

### BACKGROUND

Configurability in the memory architecture to support different interfaces for different use cases like neural computing is critical to achieving high processing speed at reasonable power level. In neural computing, wide vector access coupled with local processing is required to enable low power deep neural network (DNN) solutions having high terra operations per second (TOPS) per watt and per millimeter squared.

There is a need in the art for a configurable memory architecture that can support digital in-memory computation processing with a wide vector access and conventional memory access (read and write with error correction).

### SUMMARY

In an embodiment of a circuit, a memory array includes a plurality of sub-arrays, wherein each sub-array includes memory cells arranged in a matrix with plural rows and plural columns, each row including a word line connected to the memory cells of the row, and each column including a local bit line connected to the memory cells of the column. A word line drive circuit for each row has an output connected to drive the word line of the row. A row decoder circuit is coupled to the word line drive circuits.

A control circuit is configured to support plural modes of memory circuit operation including: a first mode where the row decoder circuit actuates only one word line in the memory array during a memory access operation and a second mode where the row decoder circuit simultaneously actuates one word line per sub-array during an in-memory computation operation.

An input/output circuit for each column comprises: a plurality of bit line inputs coupled to the local bit lines of the sub-arrays; a column data output coupled to the plurality of bit line inputs and configured to generate a column data bit for output in the first mode; and a plurality of sub-array data outputs, where each sub-array data output is coupled to a corresponding one of the plurality of bit line inputs, and configured to generate a plurality of sub-array data bits for output in the second mode.

A column read multiplexing circuit is coupled to the column data outputs of the input/output circuits for a first set of columns of the memory array to output data bits in the first mode for a first data word and coupled to the column data outputs of the input/output circuits for a second set of columns of the memory array to output data bits in the first mode for a second data word.

A processing circuit is configured to receive feature data and perform a computational operation in the second mode as a function of the feature data and the plurality of sub-array data bits.

The column read multiplexing circuit comprises: a first multiplexer having a first input coupled to the column data output of a first input/output circuit coupled to a column in said first set of columns of the memory array and a second input coupled to the column data output of a second input/output circuit coupled to a column in said second set of columns of the memory array; wherein a selection input of the first multiplexer is configured to receive a multiplexer control signal configured to select one of the first and second inputs for output depending on an address for a read operation in the first mode.

An embodiment of a system comprises: a plurality of processing tiles interconnected by a network bus; wherein each processing tile comprises one or more instances of the foregoing circuit embodiment; and wherein each processing tile is selectively configurable as a safety island when the one or more instances of the foregoing circuit embodiment are set to operate in the first mode during the memory access operation and as a processing island when the one or more instances of the foregoing circuit embodiment are set to operate in the second mode during the in-memory computation operation.

In an embodiment of a circuit, a memory array includes memory cells arranged in a matrix with plural rows and plural columns; wherein the memory array stores at least a first data word and a second data word in each row in connection with a memory access mode of operation and stores computational weight data in each row in connection with an in-memory computation mode of operation. A word line drive circuit for each row has an output connected to drive the word line of the row. A row decoder circuit is coupled to the word line drive circuits.

A control circuit is configured, in the memory access mode of operation, to actuate only one word line in the memory array, and is configured, in the in-memory computation mode of operation, to simultaneously actuate plural word lines in the memory array.

An input/output circuit for each column comprises: a first read circuit configured to read a data bit from the memory cell of the column accessed in response to actuation of the only one word line in the memory array; and a second read circuit configured to read plural data bits from the memory cells of the column accessed in response to simultaneous actuation of the plural word lines in the memory array.

A column read multiplexing circuit is coupled to the input/output circuits for a first set of columns of the memory array to output the read data bits of the first data word accessed in response to actuation of the only one word line in the memory array and is coupled to the input/output circuits for a second set of columns of the memory array to output the read data bits of the second data word accessed in response to actuation of the only one word line in the memory array.

A processing circuit is configured to receive feature data and perform a computational operation in the in-memory computation mode of operation as a function of the feature data and the read plural data bits from the memory cells of the column accessed in response to simultaneous actuation of the plural word lines in the memory array.

The column read multiplexing circuit comprises: a first multiplexer having a first input coupled to receive one read data bit of the first data word accessed in response to actuation of the only one word line in the memory array and a second input coupled to receive one read data bit of the second data word accessed in response to actuation of the only one word line in the memory array; wherein a selection input of the first multiplexer is configured to receive a multiplexer control signal configured to select one of the first and second inputs for output depending on an address for a read operation in the memory access mode of operation.

An embodiment of a system comprises: a plurality of processing tiles interconnected by a network bus; wherein each processing tile comprises one or more instances of the foregoing circuit embodiment; and wherein each processing tile is selectively configurable as a safety island when the one or more instances of the foregoing circuit embodiment are set to operate in the memory access mode of operation and as a processing island when the one or more instances of the foregoing circuit embodiment are set to operate in the in-memory computation mode of operation.

### BRIEF DESCRIPTION OF THE DRAWINGS

For a better understanding of the embodiments, reference will now be made by way of example only to the accompanying figures in which:
Figure 1 is a schematic diagram of a circuit supporting both conventional memory access processing and digital in-memory computation processing;
Figure 2 is a circuit diagram of a 6T static random access memory (SRAM) cell used in the circuit of Figure 1;
Figure 3 is a circuit diagram of an 8T SRAM cell used in the circuit of Figure 1;
Figure 4 shows a block diagram of a mixed safety mode system architecture supporting both digital in-memory computation processing with a wide vector access and conventional memory access (read and write with error correction);
Figure 5 is a schematic diagram of a portion of the system shown in Figure 4;
Figures 6A and 6B show block diagrams for an embodiment of the I/O circuit for the memory circuit in Figure 5; and
Figure 7 illustrates a block diagram for a system utilizing a plurality of processing tiles formed by the mixed safety mode system architecture of Figure 4.

### DETAILED DESCRIPTION OF THE DRAWINGS

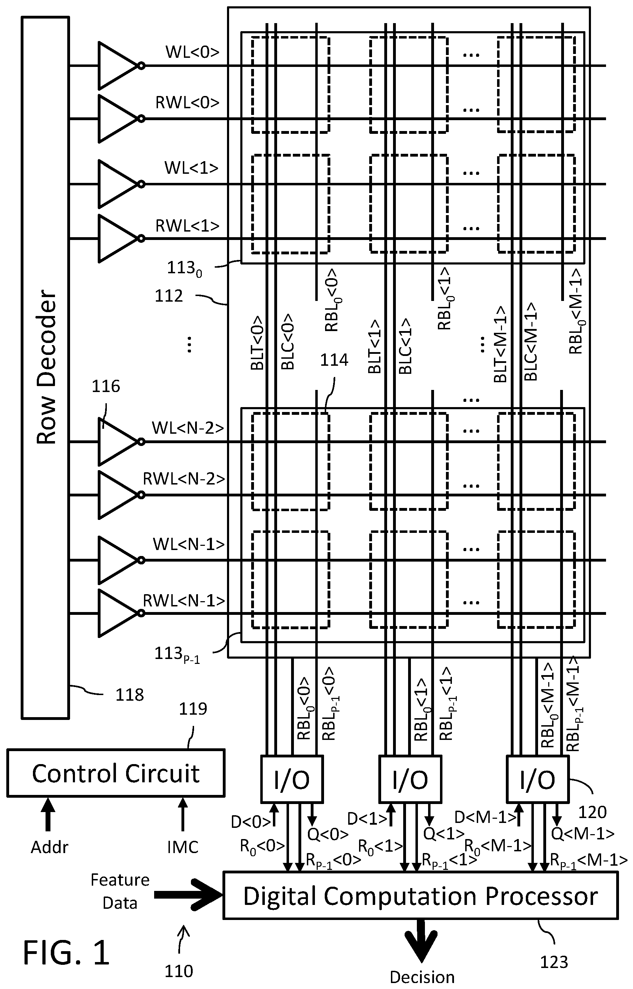

Reference is now made to Figure 1 which shows a block diagram of a circuit 110 supporting both conventional memory access processing and digital in-memory computation processing. The circuit 110 is implemented using a memory circuit which includes a static random access memory (SRAM) array 112 formed by a plurality of SRAM memory cells 114 arranged in a matrix format having N rows and M columns. Each memory cell 114 is programmed to store a bit of data. In conventional memory access processing, the stored data in the memory array 112 can be any desired user data. In digital in-memory computation processing, the stored data in the memory array 112 comprises computational weight or kernel data for a digital in-memory compute operation. In this context, the digital in-memory compute operation is understood to be a form of a high dimensional Matrix Vector Multiplication (MVM) supporting multi-bit weights that are stored in multiple bit cells of the memory. The group of bit cells (in the case of a multibit weight) can be considered as a virtual synaptic element. Each bit of data stored in the memory array, whether user data or weight data, has either a logic "1" or a logic "0" value.

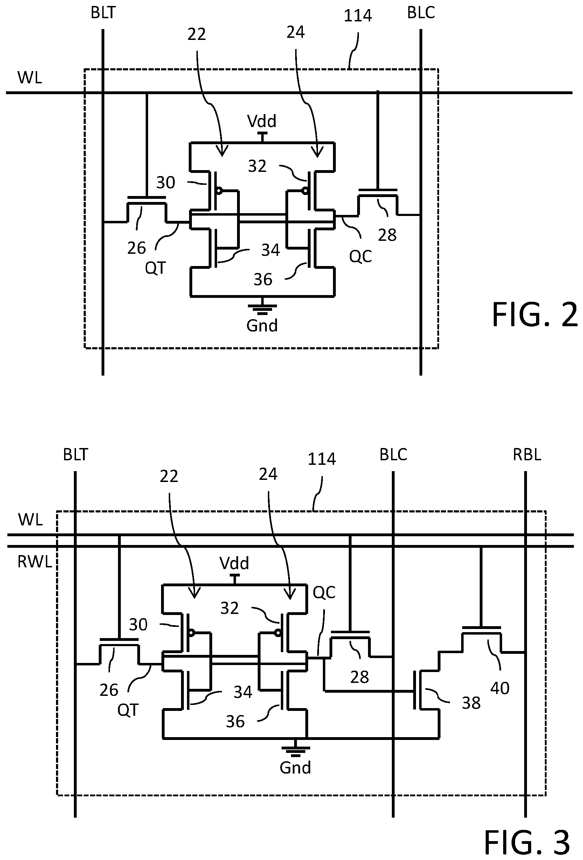

Each SRAM memory cell 114 may comprise a 6T-type memory cell as shown in Figure 2. The cell 114 includes two cross-coupled CMOS inverters 22 and 24, each inverter including a series connected p-channel and n-channel MOSFET transistor pair. The inputs and outputs of the inverters 22 and 24 are coupled to form a latch circuit having a true data storage node QT and a complement data storage node QC which store complementary logic states of the stored data bit. The cell 14 further includes two transfer (passgate) transistors 26 and 28 whose gate terminals are driven by a word line WL. The source-drain path of transistor 26 is connected between the true data storage node QT and a node associated with a true bit line BLT. The source-drain path of transistor 28 is connected between the complement data storage node QC and a node associated with a complement bit line BLC. The source terminals of the p-channel transistors 30 and 32 in each inverter 22 and 24 are coupled to receive a high supply voltage (for example, Vdd) at a high supply node, while the source terminals of the n-channel transistors 34 and 36 in each inverter 22 and 24 are coupled to receive a low supply voltage (for example, ground (Gnd) reference) at a low supply node.

Alternatively, each SRAM memory cell 114 may comprise an 8T-type memory cell as shown in Figure 3. The cell 114 includes two cross-coupled CMOS inverters 22 and 24, each inverter including a series connected p-channel and n-channel MOSFET transistor pair. The inputs and outputs of the inverters 22 and 24 are coupled to form a latch circuit having a true data storage node QT and a complement data storage node QC which store complementary logic states of the stored data bit. The cell 14 further includes two transfer (passgate) transistors 26 and 28 whose gate terminals are driven by a word line WL. The source-drain path of transistor 26 is connected between the true data storage node QT and a node associated with a true bit line BLT. The source-drain path of transistor 28 is connected between the complement data storage node QC and a node associated with a complement bit line BLC. The source terminals of the p-channel transistors 30 and 32 in each inverter 22 and 24 are coupled to receive a high supply voltage (for example, Vdd) at a high supply node, while the source terminals of the n-channel transistors 34 and 36 in each inverter 22 and 24 are coupled to receive a low supply voltage (for example, ground (Gnd) reference) at a low supply node. A signal path between the read bit line RBL and the low supply voltage reference is formed by series coupled transistors 38 and 40. The gate terminal of the (read) transistor 38 is coupled to the complement storage node QC and the gate terminal of the (transfer) transistor 40 is coupled to receive the signal on the read word line RWL.

It will be understood that the circuit 110 may instead use a different type of memory cell, for example, any form of a bit cell, storage element or synaptic element producing a deterministic readout arranged in an array. As a non-limiting example, consideration is made for the use of a non-volatile memory (NVM) cell such as, for example, magnetoresistive RAM (MRAM) cell, Flash memory cell, phase change memory (PCM) cell or resistive RAM (RRAM) cell). In the following discussion, focus is made on the implementation using an 8T-type SRAM cell 114, but this is done by way of a non-limiting example, understanding that any suitable memory element could be used (e.g., a binary (two level) storage element or an m-ary (multi-level) storage element).

Each cell 114 includes a word line WL, a pair of complementary bit lines BLT and BLC, a read word line RWL and a read bit line RBL. The SRAM memory cells in a common row of the matrix are connected to each other through a common word line WL and through a common read word line RWL. Each of the word lines (WL and/or RWL) is driven by a word line driver circuit 116 with a word line signal generated by a row decoder circuit 118 during read and write operations. The SRAM memory cells in a common column of the matrix across the whole array 112 are connected to each other through a common pair of complementary (write) bit lines BLT and BLC. The array 112 is segmented into P sub-arrays 113₀ to 113_{P-1}. Each sub-array 113 includes M columns and N/P rows of memory cells 114. The SRAM memory cells in a common column of each sub-array 113 are connected to each other through a local read bit line RBL.

The P local read bit lines RBL₀<x> to RBL_{P-1}<x> from the sub-arrays 113 for the column x in the array 112 are coupled, along with the common pair of complementary bit lines BLT<x> and BLC<x> for the column x in the array 112, to a column input/output (I/O) circuit 120(x). Here, x = 0 to M-1. A data input port (D) of the column I/O circuit 120 receives input data (user or weight data) to be written to an SRAM memory cell 114 in the column through the pair of complementary bit lines BLT, BLC in response to assertion of a word line signal in a conventional memory access mode of operation. A data output port (Q) of the column I/O circuit 120 generates output data read from an SRAM memory cell 14 in the column through the read bit line RBL in response to assertion of a read word line signal in the conventional memory access mode of operation. Additionally, the column I/O circuit 120 further includes P sub-array data output ports R₀ to R_{P-1} to generate output data read from a memory cell 114 on the local read bit line RBL of the corresponding sub-array 113₀ to 113_{P-1}, respectively, in response to the simultaneous assertion of a plurality of read word line signals (one per sub-array 113) in a digital in-memory compute mode of operation. A digital computation processing circuit 123 performs digital computations on the output data from the sub-array data output ports R as a function of received feature data and generates a decision output for the digital in-memory compute operation. The processing circuit 123 can implement computation logic for the digital signal processing in a number of ways including: full support of Boolean operations (XOR, XNOR, NAND, NOR, etc.) and vector operations depending on system and application needs; accumulation pipeline operations where vector multiplication is supported within the memory; and matrix vector multiplication pipeline operations where output from the memory as one vector for the multiply and accumulate (MAC) function. It will be noted that the processing circuit 123 is an integral part of the digital in-memory computation circuit 110.

The computation logic for the digital signal processing performed by processing circuit 123 is closely integrated with the input/output circuits and the sub-array data output ports R₀ to R_{P-1} to support utilization of a wide (for example, P times) vector access. There are a number of figure of merit (FOM) benefits which accrue from this solution including: enabling multi-word access in a same cycle amortizes the common logic toggling power inside the SRAM when wide vector access occurs; the use of sub-arrays 113 can reduce bit line toggling power consumption (i.e., where P word lines are asserted in parallel to access P corresponding sub-arrays); support of both, with the opportunity to toggle between, the conventional memory access mode of operation and the digital in-memory compute mode of operation; and on/off current ratio on the same bitline improves which is a key concern when the circuitry is implemented using fully-depleted silicon-on-insulator (FDSOI) technology where forward body bias is aggressively used.

It will be noted that the circuit 110 presents a conventional SRAM interface through the data input ports D and the data output ports Q in accordance with the conventional memory access mode of operation. In response to an applied memory address (Addr), the circuit supports read (via data output ports Q) and write (via data input ports D) access to a single row of memory cells 114 in the array 112 by the selected assertion of a single word line WL or RWL. The circuit further presents a sub-array processing interface through the sub-array data output ports R₀ to R_{P-1} in accordance with the digital in-memory compute mode of operation. In response to an applied memory address (Addr), the circuit supports simultaneous read (via data output ports R₀ to R_{P-1}) access to a single row of memory cells 114 in each of the sub-arrays 113₀ to 113_{P-1} by the simultaneous assertion of corresponding read word lines RWL. A single address can be decoded to select the plural word lines (one per sub-array 113) for assertion, or plural addresses can be decoded to select the plural word lines (one per sub-array 113) for assertion. The use plural sub-arrays 113 in this mode enables parallelism supporting very wide access for computation processing without sacrificing density. Advantageously, this digital in-memory compute mode of operation utilizes the resources of the conventional SRAM design with modified control, decoding and input/output circuits (as will be discussed herein in detail) to enable parallel access in the digital in-memory compute mode of operation with additional control to toggle between the conventional memory access mode of operation and the digital in-memory compute mode of operation as needed by the system application. This architecture brings parallelism with usage of the push rule bitcell thus enabling high density/compute density when configured for the in-memory compute mode of operation. Notwithstanding the foregoing, as noted above, usage of other bitcell types may instead be made.

A control circuit 119 controls mode operations of the circuitry within the circuit 110 responsive to the logic state of a control signal IMC. When the control signal IMC is in a first logic state (for example, logic low), the circuit 110 operates in accordance with the conventional memory access mode of operation (for writing data from data input port D to the memory array or reading data from the memory array to data output port Q). Conversely, when the control signal IMC is in a second logic state (for example, logic high), the circuit 110 operates in accordance with the digital in-memory compute mode of operation (for reading weight data from the memory array to the sub-array data output ports R).

When the circuit 110 is operating in the conventional memory access mode of operation, the row decoder circuit 118 decodes a received address (Addr), selectively actuates only one word line WL (during write) or one read word line RWL (during read) for the whole array 112 with a word line signal pulse to access a corresponding single one of the rows of memory cells 114. In write, logic states of the data at the input ports D are written by the column I/O circuits 120 through the pairs of complementary bit lines BLT, BLC to the single row of memory cells coupled to the accessed word line WL. In read, the logic states of the data stored in the single row of memory cells coupled to the accessed word line WL are output from the read bit lines RBL to the column I/O circuits 120 for output at the data output ports Q.

When the circuit 110 is operating in the digital in-memory compute mode of operation, the row decoder circuit 118 decodes a received address (Addr), selectively (and simultaneously) actuates one read word line RWL in each sub-array 113 in the memory array 112 with a word line signal pulse to access a corresponding row of memory cells 114 in each sub-array 113. The logic states of the weight data stored in the row of memory cells coupled to the accessed read word line RWL in each sub-array 113 are passed from the read bit lines RBL₀<x> to RBL_{P-1}<x> to the column I/O circuit 120 for output at the corresponding sub-array data output ports R₀ to R_{P-1}.

It will be noted that each sub-array 113 output can be considered as one subtensor/tensor for processing operations. Additionally, multiple sub-arrays 113 outputs can be grouped as a larger tensor. The grouping of sub-array outputs can be made across columns, across rows, or both. Such processing is supported through the configuration and operation of the processing circuit 123.

The architecture shown in Figure 1 presents a number of advantages for digital in-memory computation including: very wide vector access is enabled for supporting high dimensional tensor processing for an artificial neural network (ANN); hyper dimensional computing for artificial intelligence (AI) training and inference workloads is also supported; the computation is deterministic with a wide range of weight data and feature data precisions and number formats permitted for neural network applications (noting that this is a significant differentiation versus analog in-memory computation - which is limited to simplified signed/unsigned integer formats); and the solution is extendable to incorporate additional stochastic compute modes to gain area and power efficiency.

A concern with the architecture of Figure 1 is safety compatibility. It is critical in safety applications for the circuit 110, such as in automotive applications, that the memory architecture be safety compliant. By this it is meant that measures be taken to account for the possibility of bitcell errors in the data stored by the memory. Such bitcell errors can arise, for example, as a result of a radiation exposure.

Known types of memory error due to a single event upset (SEU) include: a single bit upset (SBU) error where the logic state of one bit in the array is flipped and a multiple cell upset (MCU) where the logic state of two or more adjacent bits in the array are flipped.

The provision of error correction coding (ECC) bits with the storage of data words in the memory can assist with the detection and correction of some single event upset errors. Further protection can be provided through the use of data word interleaving at each row of the memory based on a column multiplexing (MUX) factor. For example, in a memory supporting data word interleaving with a column MUX factor of two, there are two data words stored on each row of the memory and the bits of those two data words are interleaved with each other. ECC bits can be provided for each of the two data words.

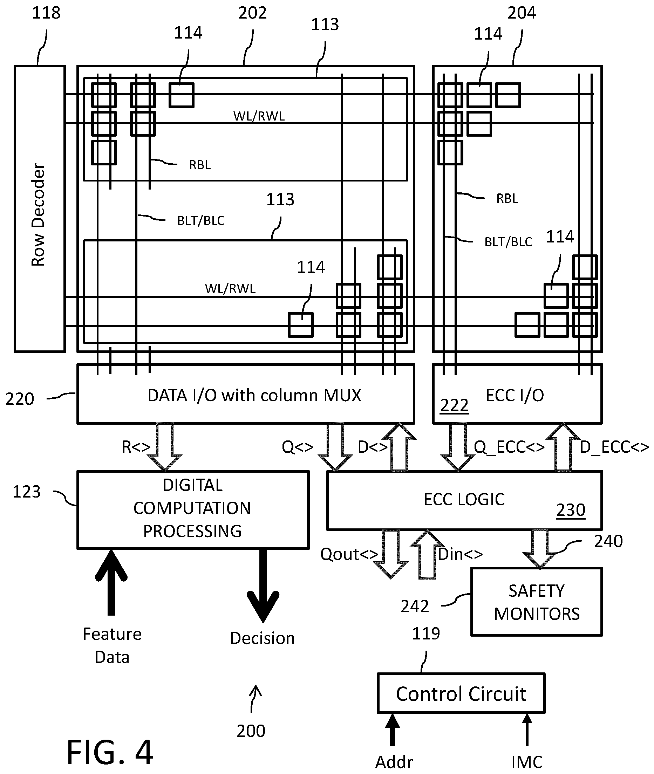

Reference is now made to Figure 4 which shows a block diagram of a mixed safety mode system 200 architecture supporting both digital in-memory computation processing with a wide vector access and conventional memory access (read and write with error correction). The system 200 includes a first memory array 202 and a second memory array 204. The first memory array 202 stores in-memory computation weight data and/or system data, and the second memory array 204 stores error correction code (ECC) data generated using conventional error correction coding operation from the weight data and/or system data stored in the first memory array 202. The memory array 202 and the second memory array 204 may be implemented as shared same physical memory.

The first memory array 202 is arranged in a manner like that shown with the memory array 112 of Figure 1 to include memory cells 114 arranged in a matrix with the array 112 being segmented into plural sub-arrays 113. The second memory array 204 also includes memory cells 114 arranged in a matrix. The memory cells 114 in a common row of the matrices for the arrays 202 and 202 are connected to each other through a common word line WL and through a common read word line RWL. Each of the word lines (WL and/or RWL) is driven by a word line driver circuit (reference 116, Figure 1) in response to an activation by a row decoder 118. The memory cells 114 in a common column of the matrices for array 202 and array 204 are connected to each other through a common pair of complementary (write) bit lines BLT and BLC. The memory cells 114 in a common column of each sub-array 113 within the array 202 are connected to each other through a local read bit line RBL. The memory cells 114 in a common column of the matrix for array 204 are connected to each other through a common read bit line RBL.

The local read bit lines RBL from the sub-arrays 113 for each column in the array 202 are coupled, along with the complementary bit lines BLT and BLC for the column in the array 202, to a data input/output (I/O) circuit 220. A data input port (D<>) of the I/O circuit 220 receives input data (user or weight data) to be written to the memory cells 114 in array 202 through the complementary bit lines BLT, BLC in response to assertion of a word line signal in a conventional memory access mode of operation. A data output port (Q<>) of the I/O circuit 220 generates output data read from the memory cells 114 of array 202 through the read bit lines RBL in response to assertion of a read word line signal in the conventional memory access mode of operation. Additionally, the I/O circuit 220 further includes sub-array data output ports R<> to generate output data read from memory cells 114 on the local read bit lines RBL of the sub-arrays 113 of array 202 in response to the simultaneous assertion of a plurality of read word line signals (one per sub-array 113) in a digital in-memory compute mode of operation. A digital computation processing circuit 123 performs digital computations on the output data from the sub-array data output ports R<> as a function of received feature data and generates a decision output for the digital in-memory compute operation.

The read bit lines RBL for each column in the array 204 are coupled, along with the complementary bit lines BLT and BLC for the column in the array 204, to an ECC input/output (I/O) circuit 222. An ECC data input port (D_ECC<>) of the I/O circuit 222 receives ECC data to be written to the memory cells 114 in array 204 through the complementary bit lines BLT, BLC in response to assertion of a word line signal in the conventional memory access mode of operation. An ECC data output port (Q_ECC<>) of the I/O circuit 222 generates output ECC data read from the memory cells 114 of array 204 through the read bit lines RBL in response to assertion of a read word line signal in the conventional memory access mode of operation.

An ECC logic circuit 230 functions to generate the ECC data to be written to the memory cells 114 in array 204 in response to input data (user or weight data) received at an input data port (Din<>). The ECC data is calculated as a function of the input data in a manner well known in the art. The input data from input data port Din<> is then passed by the ECC logic circuit 230 to the data input port (D<>) of the I/O circuit 220 to be written to the memory cells of the array 202. The calculated ECC data is passed by the ECC logic circuit 230 to the ECC data input port (D_ECC<>) of the I/O circuit 222 to be written to the memory cells of the array 204.

The ECC logic circuit 230 further functions to perform the error detection and correction function. The data read from the memory cells 114 of array 202 and output through the output port (Q<>) of the I/O circuit 220 and the ECC data read from the memory cells 114 of array 204 and output through the ECC data output port (Q_ECC<>) of the I/O circuit 222 are processed by the ECC logic circuit 230 in a manner well known in the art to identify the existence of errors in the data read from the memory cells 114 of array 202 and further correct, to the degree possible dependent on the ECC scheme employed, those errors. The corrected data is then output by the ECC logic circuit 230 through corrected data output port Qout<>. Additionally, in response to a correction being made to the read data word, the ECC logic circuit 230 may further operate to write that corrected data word back into the memory array. In the event the ECC logic circuit 230 detects the existence of an error (for example, a bit flip due to a SEU as noted above) in the data read from the memory cells 114 of array 202 through output port (Q<>) of the I/O circuit 220, an error flag signal 240 may be generated by the ECC logic circuit 230 and passed to a safety monitor circuit 242. In an embodiment, the error flag signal 240 may be asserted in the case of any detected data error. Alternatively, the error flag signal 240 may be asserted only in the case where an uncorrected (or uncorrectable) data error is detected.

In an embodiment, the ECC logic circuit 230 may be implemented using the known single error correction double error detection (SECDED) code process known to those skilled in the art.

The data input/output (I/O) circuit 220 is implemented to support read-write of data words with word interleaving based on a column multiplexing factor. In a non-limiting example of this, consider an implementation with a column multiplexing factor of two. Each row of the memory array 202 stores two data words (the number of data words stored per row corresponding to the column multiplexing factor), with the bits of those two data words being interleaved with each other. Thus, in this example, the bits of the first data word stored at a given row would be stored in the memory cells 114 for the even numbered columns of the array 202 and the bits of the second data word stored at that same given row would be stored in the memory cells 114 for the odd numbered columns of the array 202. The ECC bits calculated for the first data word and second data word would be stored at the same row within the array 204. These ECC bits may be stored in the array 204, in a manner similar to the storage of the data words themselves in the array 202, with interleaving based on the same column multiplexing factor. Thus, the ECC bits for the first data word could be stored at the same given row in the memory cells 114 for the even numbered columns of the array 204 and the ECC bits for the second data word could be stored at that same given row in the memory cells 114 for the odd numbered columns of the array 204.

The data write operation proceeds as follows:
The ECC logic circuit 230 receives the first data word comprising input data (user or weight data) at the input data port (Din<>). The ECC data is calculated as a function of the input data. The ECC logic circuit 230 passes the first data word to the data input port (D<>) of the I/O circuit 220. Using the column multiplexing functionality, the I/O circuit 220 applies the bits of the first data word to the complementary bit lines BLT and BLC for the even columns in the array 202 and writes those bits to the corresponding memory cells 114 at the row selected by the row decoder circuit 118. Likewise, using the column multiplexing functionality, the I/O circuit 222 applies the bits of the ECC data for the first data word to the complementary bit lines BLT and BLC for the even columns in the array 204 and writes those bits to the corresponding memory cells 114 at the same row selected by the row decoder circuit 118.

The ECC logic circuit 230 next receives the second data word comprising input data (user or weight data) at the input data port (Din<>). The ECC data is calculated as a function of the input data. The ECC logic circuit 230 passes the second data word to the data input port (D<>) of the I/O circuit 220. Using the column multiplexing functionality, the I/O circuit 220 applies the bits of the second data word to the complementary bit lines BLT and BLC for the odd columns in the array 202 and writes those bits to the corresponding memory cells 114 at the same row selected by the row decoder circuit 118. Likewise, using the column multiplexing functionality, the I/O circuit 222 applies the bits of the ECC data for the second data word to the complementary bit lines BLT and BLC for the odd columns in the array 204 and writes those bits to the corresponding memory cells 114 at the same row selected by the row decoder circuit 118.

The data read operation proceeds as follows:
The row is selected by the row decoder circuit 118 and, using the column multiplexing functionality, the I/O circuit 220 reads the data for the first data word from the memory cells 114 connected to the read bit lines RBL for the even columns in the array 202. The read first data word is passed through output port (Q<>) of the I/O circuit 220 to the ECC logic circuit 230. At the same time, using the column multiplexing functionality, the I/O circuit 222 reads the ECC data for that first data word from the memory cells 114 connected to the read bit lines RBL for the even columns in the array 204. The read ECC data is passed through output port (Q_ECC<>) of the I/O circuit 222 to the ECC logic circuit 230. The ECC logic circuit 230 processes the read first data word and the read ECC data to identify the existence of errors in the read first data word and further correct, to the degree possible dependent on the ECC scheme employed, those errors. The corrected first data word is then output by the ECC logic circuit 230 through corrected data output port Qout<>. It will be noted that in response to a correction being made to the read data word, that corrected data word can then be written back into the memory array at the same address location.

Next, using the column multiplexing functionality, the I/O circuit 220 reads the data for the second data word from the memory cells 114 connected to the read bit lines RBL for the odd columns in the array 202. The read second data word is passed through output port (Q<>) of the I/O circuit 220 to the ECC logic circuit 230. At the same time, using the column multiplexing functionality, the I/O circuit 222 reads the ECC data for that second data word from the memory cells 114 connected to the read bit lines RBL for the odd columns in the array 204. The read ECC data is passed through output port (Q_ECC<>) of the I/O circuit 222 to the ECC logic circuit 230. The ECC logic circuit 230 processes the read second data word and the read ECC data to identify the existence of errors in the read first data word and further correct, to the degree possible dependent on the ECC scheme employed, those errors. The corrected second data word is then output by the ECC logic circuit 230 through corrected data output port Qout<>. Again, it will be noted that in response to a correction being made to the read data word, that corrected data word can then be written back into the memory array at the same address location.

The foregoing write and read operations utilizing word interleaving based on a column multiplexing factor are performed in the context of the conventional memory access mode of operation. In support of wide vector access during the digital in-memory compute mode of operation, however, the word interleaving based on the column multiplexing factor is not implemented. Furthermore, operation of the ECC process is bypassed for the digital in-memory compute mode of operation.

It will be noted that the implementation described above with a column multiplexing factor of two is just an example. The I/O circuits 220 and 222 for the arrays 202 and 204, respectively, may be configured to support any desired column multiplexing factor, example of such being a MUX factor equal to a power of 2, such as 2, 4, 8 or 16 depending on considerations of array size and degree to which numbers of error detection and error correction using the ECC logic 230 are necessary. The selection of the MUX factor may also, or alternatively, be made dependent on the data processing application.

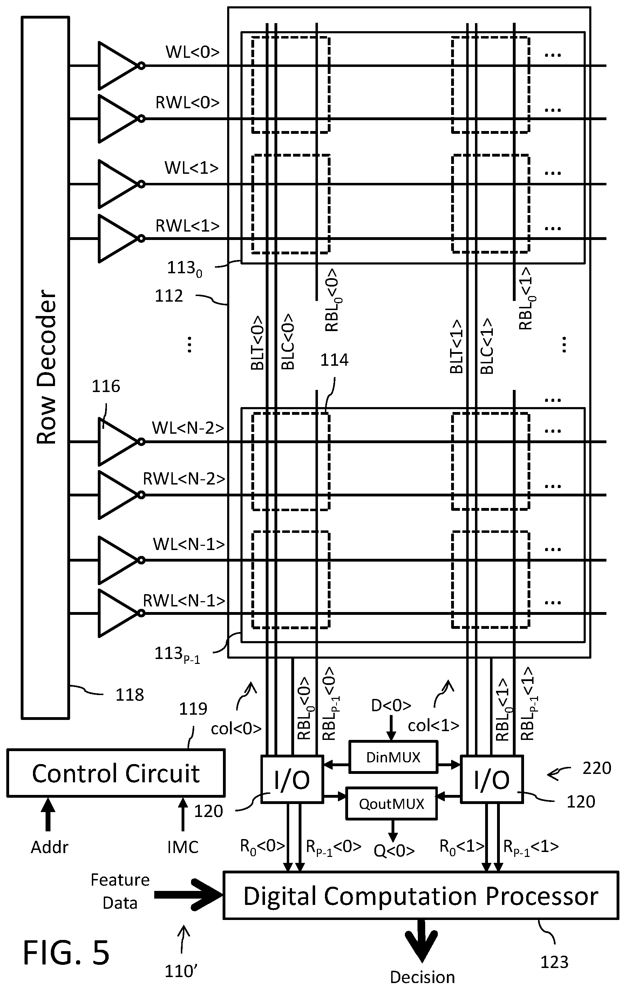

Reference is now made to Figure 5 showing a circuit 110' supporting both conventional memory access processing and digital in-memory computation processing. Like references in Figures 1 and 5 refer to same or similar components, the description of which will not necessarily be repeated for the sake of brevity. The circuit 110' of Figure 5 differs from the circuit 110 of Figure 1 primarily in terms of illustrating details for implementing read-write of data words with word interleaving based on a column multiplexing factor. In particular, Figure 5 shows implementation with a column multiplexing factor equal to two (wherein this MUX factor = 2 is just by example it being understood that higher factors could instead be implemented depending on system need). A simplification of the array 112, corresponding for example to the array 202 of Figure 4, shows one even column (referenced as col<0>) and one odd column (referenced as col<1>) associated with a single bit (here bit <0>) of the data input D and data output Q in the conventional memory access mode of operation. These columns col<0> and col<1> are adjacent to each other in the array 112, 202. The array 112, 202 would, of course, include a number of even-odd pairs of columns configured in the same manner as the illustrated even-odd pair of columns.

Each column of the array 112, 202 includes an input/output circuit 120.

A data input port (D) for the column MUX=2 columns col<0> and col<1> is selectively connected through a data input column multiplexer DinMUX to an internal data input path of each of the corresponding column I/O circuits 120. A bit of the input data (user or weight data) of a data word received at the data input port D can be routed by the data input column multiplexer DinMUX to the column I/O circuit 120 for the column col<0> when the data word write in the conventional memory access mode of operation is writing the data word to the complementary bit lines BLT and BLC for the even columns in the array 112, 202. Alternatively, the bit of the input data (user or weight data) of the data word received at the data input port D can be routed by the data input column multiplexer DinMUX to the column I/O circuit 120 for the column col<1> when the data word write in the conventional memory access mode of operation is writing the data word to the complementary bit lines BLT and BLC for the odd columns in the array 112, 202.

The bit of the input data (user or weight data) of the data word received at the data input port D is supplied, as shown in Figure 4 for example, by the ECC logic circuit 230 in the conventional memory access mode of operation.

A data output port (Q) for the column MUX=2 columns col<0> and col<1> is selectively connected through a data output column multiplexer QoutMUX to an internal data output path of each of the corresponding column I/O circuits 120. A bit of the output data (user or weight data) of a data word read by the column I/O circuit 120 for the column col<0> can be routed by the data output column multiplexer QoutMUX to the data output port Q when the data word read in the conventional memory access mode of operation is reading the data word from the read bit lines RBL for the even columns in the array 112, 202. Alternatively, the bit of the output data (user or weight data) of the data word read by the column I/O circuit 120 for the column col<1> can be routed by the data output column multiplexer QoutMUX to the data output port Q when the data word read in the conventional memory access mode of operation is reading the data word from the read bit lines RBL for the odd columns in the array 112, 202.

The bit of the output data (user or weight data) of the data word supplied at the data output port Q is provided, as shown in Figure 4 for example, to the ECC logic circuit 230 in the conventional memory access mode of operation.

The included data output column multiplexers QoutMUX form a column read multiplexing circuit that is coupled to the internal data output paths (i.e., the column data outputs) of the input/output circuits 120 for a first set of columns of the memory array (for example, the even columns) to output data bits in the conventional memory access mode (read) for a first data word stored at a given row of the array 112, and coupled to the internal data output paths (i.e., the column data outputs) of the input/output circuits 120 for a second set of columns of the memory array (for example, the odd columns) to output data bits in the conventional memory access mode (read) for a second data word stored at that given row of the array 112.

The included data input column multiplexers DinMUX form a column write multiplexing circuit that is coupled to the internal data input paths (i.e., the column data inputs) of the input/output circuits 120 for the first set of columns of the memory array (for example, the even columns) to input data bits in the conventional memory access mode (write) for the first data word stored at the given row of the array 112, and coupled to the internal data input paths (i.e., the column data inputs) of the input/output circuits 120 for the second set of columns of the memory array (for example, the odd columns) to input data bits in the conventional memory access mode (write) for the second data word stored at the given row of the array 112.

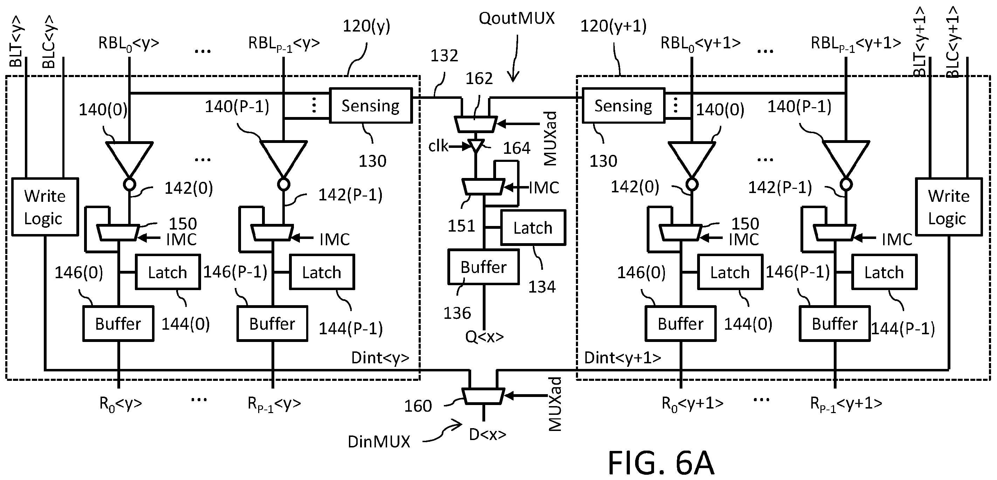

A block diagram of an embodiment for the data input/output (I/O) circuit 220 is shown in Figure 6A. The circuit 220 includes a plurality of column I/O circuits 120. Each column I/O circuit 120(y) is coupled to the pair of complementary bit lines BLT<y>, BLC<y> for the column y in the array 112. The bit at an internal data input path Dint<y> is coupled through a write logic circuit to drive the pair of complementary bit lines. The column I/O circuit 120(y) is also coupled to the P local read bit lines RBL₀<y> to RBL_{P-1}<y> from the sub-arrays 113 for the column y in the array 112 through a read logic circuit.

A sensing circuit 130 of the read logic circuit is coupled to receive the data on the P local read bit lines RBL₀<y> to RBL_{P-1}<y> and generate a sensed data bit on signal line 132. As an example, the sensing circuit 130 may comprise a logic NAND gate.

A sensing circuit 140(z) of the read logic circuit is coupled to receive the data on the local read bit line RBL_{z}<y> and generate a sensed data bit on signal line 142(z). Here, z = 0 to P-1. As an example, each sensing circuit 140 may comprise a logic NOT gate, for example, or a sense amplifier. The sensed data bit is applied to the second input of a multiplexer circuit 150 whose select input receives the control signal IMC. The first input of the multiplexer circuit 150 is coupled to the output of the multiplexer circuit 150. The data at the output of multiplexer circuit 150 is latched by latch circuit 144(z) and buffered by buffer circuit 146(z) for output at the sub-array data output port R_{z}<y>. When the control signal IMC is in the first logic state (for example, logic low - when the circuit 110' is operating in accordance with the conventional memory access mode of operation), the multiplexer circuit 150 selects the data at the output of the multiplexer circuit 150 (i.e., the data held by the latch 144). Conversely, when the control signal IMC is in the second logic state (for example, logic high - when the circuit 110' is operating in accordance with the digital in-memory compute mode of operation), the multiplexer circuit 150 selects the data on signal line 142.

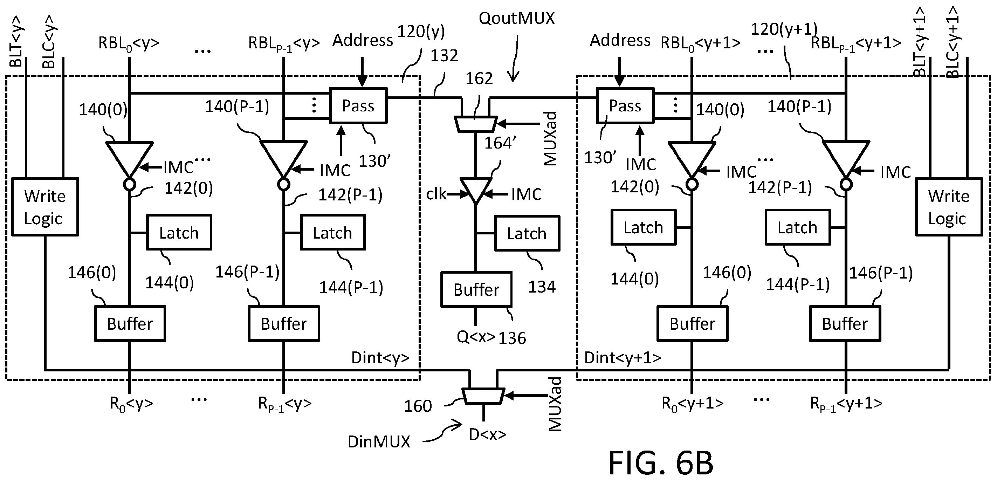

To support read-write of data words with word interleaving based on a column multiplexing factor, the data input/output (I/O) circuit 220 further includes a data input column multiplexer DinMUX and a data output column multiplexer QoutMUX. Figure 6 illustrates the configuration for the data input column multiplexer DinMUX and a data output column multiplexer QoutMUX coupled to plural column I/O circuit 120 for the example implementation with a column multiplexing factor equal to two. Again, the column MUX=2 implementation is just an example, and those skilled in the art will understand how to extend this to other column multiplexing factors.

The data input column multiplexer DinMUX includes a multiplexing circuit 160 having an input coupled to receive bit <x> of the input data word, a first output coupled to the internal data input path Dint<y> for the column I/O circuit 120<y> coupled through the write logic to the complementary bit lines BLT<y>, BLC<y> for the even column, and a second output coupled to the internal data input path Dint<y+1> for the column I/O circuit 120<y+1> coupled through the write logic to the complementary bit lines BLT<y+1>, BLC<y+1> for the odd column. The select input of the multiplexing circuit 160 receives an address control signal MUXad that is generated in response to decoding of the address for the memory access (read-write) operation in the conventional memory access mode of operation to select either the even columns or the odd columns.

The data output column multiplexer QoutMUX includes a multiplexing circuit 162 having a first input coupled to receive the sensed data bit on signal line 132 output by the sensing circuit 130 of the column I/O circuit 120<y> coupled to the local read bit lines RBL₀<y> to RBL_{P-1}<y> for the even column, a second input coupled to receive the sensed data bit on signal line 132 output by the sensing circuit 130 of the column I/O circuit 120<y+1> coupled to the local read bit lines RBL₀<y+1> to RBL_{P-1}<y+1> for the odd column, and an output. The select input of the multiplexing circuit 162 receives the address control signal MUXad that is generated in response to decoding of the address for the memory access (read-write) operation in the conventional memory access mode of operation to select either the even columns or the odd columns. The sensed data bit selected by the multiplexing circuit 162 for output is applied through a gating circuit 164 to the first input of a multiplexer circuit 151. The gating circuit 164 is controlled to pass the sensed data bit in response to assertion of a sense clock signal clk. The second input of the multiplexer circuit 151 is coupled to the output of the multiplexer circuit 151. The select input of the multiplexer circuit 151 receives the control signal IMC. The data at the output of multiplexer circuit 151 is latched by latch circuit 134 and buffered by buffer circuit 136 for output at the data output port Q<x>. When the control signal IMC is in the first logic state (for example, logic low - when the circuit 110' is operating in accordance with the conventional memory access mode of operation), the multiplexer circuit 151 selects the data on signal line 132. Conversely, when the control signal IMC is in the second logic state (for example, logic high - when the circuit 110' is operating in accordance with the digital in-memory compute mode of operation), the multiplexer circuit 151 selects the data at the output of the multiplexer circuit 151 (i.e., the data held by the latch 134).

A block diagram of an alternative embodiment for the data input/output (I/O) circuit 220 is shown in Figure 6B. Like references in Figures 6A and 6B refer to same or similar components. The embodiment of Figure 6B differs from the embodiment of Figure 6A in the following ways.

The multiplexer circuit 150 is omitted, with the output of the sensing circuit 140 coupled directly to the latch 144 and buffer 146. The sensing circuit 140 is implemented with a circuit supporting a selectable tri-stated output node, where the tri-stated condition is controlled by the logic state of the control signal IMC.

The sensing circuit 130 is replaced with a pass through circuit 130'. The circuit 130' is coupled to receive the data on the P local read bit lines RBL0<y> to RBLP-1<y>, and selectively pass (dependent on the applied address (Address)) one of the signals on the P local read bit lines RBL0<y> to RBLP-1<y> for output to signal line 132. Additionally, the pass through function performed by circuit 130' may be selectively controlled by the logic state of the control signal IMC. For example, pass through of the data from the selected one of the P local read bit lines RBL0<y> to RBLP-1<y> to line 132 may occur only when the control signal IMC is in the second logic state (for example, logic high - when the circuit 110' is operating in accordance with the digital in-memory compute mode of operation).

The gating circuit 164 is implemented to include a sensing circuit 164' functionality in addition to the clock controlled gating. The sensing circuit 164' is implemented with a circuit supporting a selectable tri-stated output node, where the tri-stated condition is controlled by the logic state of the control signal IMC.

Lastly, the multiplexer circuit 151 is omitted, with the output of the sensing circuit 164' coupled directly to the latch 134 and buffer 136.

Operation of the data input/output (I/O) circuit 220 as shown in Figure 6B is similar to that described above with respect to the embodiment of Figure 6A. With respect to the operation of the sensing circuit 140, when the control signal IMC is in the first logic state (for example, logic low - when the circuit 110' is operating in accordance with the conventional memory access mode of operation), the sensing circuit 140 will have its output node controlled in the tristated condition. Conversely, when the control signal IMC is in the second logic state (for example, logic high - when the circuit 110' is operating in accordance with the digital in-memory compute mode of operation), the output of the sensing circuit 140 is enabled to drive the inputs of the latch 144 and buffer 146 with the sensed data.

With respect to the operation of the sensing circuit 164', when the control signal IMC is in the first logic state (for example, logic low - when the circuit 110' is operating in accordance with the conventional memory access mode of operation), the output of the sensing circuit 164' is enabled to drive the inputs of the latch 134 and buffer 136 with the sensed data. Conversely, when the control signal IMC is in the second logic state (for example, logic high - when the circuit 110' is operating in accordance with the digital in-memory compute mode of operation), the sensing circuit 164' will have its output node controlled in the tristated condition.

It will also be noted that the clock for each of the latch circuits 134, 144 can be selectively gated dependent on the logic state of the control signal IMC. For example, the clock for latch circuit 134 is gated through when the control signal IMC is in the second logic state (for example, logic high - when the circuit 110' is operating in accordance with the digital in-memory compute mode of operation), and the clock for latch circuit 144 is gated through when the control signal IMC is in the first logic state (for example, logic low - when the circuit 110' is operating in accordance with the conventional memory access mode of operation).

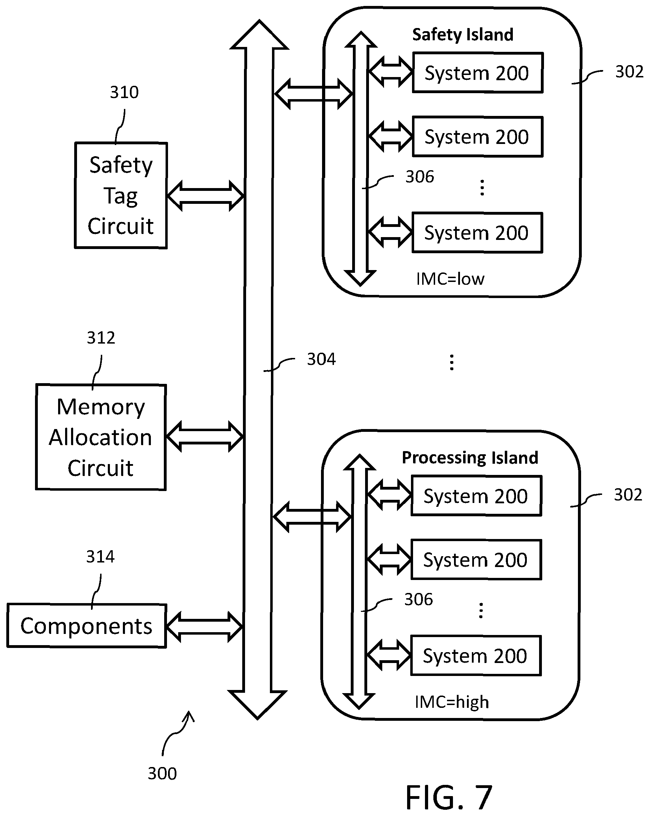

Reference is now made to Figure 7 which illustrates a block diagram for a system 300 utilizing a plurality of processing tiles 302 interconnected by a network bus 304. Each processing tile 302 may be formed by one or more instances of the mixed safety mode system 200 architecture of Figure 4 interconnected by a tile bus 306. The mixed safety mode system(s) 200 for a given one of the processing tiles 302 operate in parallel and may be configured as a safety island for the system 300 by setting the control signal IMC for that system 200 in the first logic state (for example, logic low - so that the circuit 110' operates in accordance with the conventional memory access mode of operation where word interleaving based on a column multiplexing factor and ECC protection is provided for data read-write). Conversely, the mixed safety mode system(s) 200 for a different one of the processing tiles 302 may be configured as a processing island by setting the control signal IMC in the second logic state (for example, logic high - so that the circuit 110' is operating in accordance with the digital in-memory compute mode of operation, word interleaving based on a column multiplexing factor is disabled and the ECC protection is bypassed).

The system 300 is distinguished by a dynamic, multi-island configuration that separates into safety and processing islands to improve operational safety and efficiency. The architecture is specifically designed to dynamically allocate system resources, isolating safety-critical functions within safety islands, which are dedicated to essential monitoring and control tasks. These islands maintain system integrity and operate independently to prevent critical operation failures. In contrast, processing islands are tasked with computational and data processing duties, capable of scaling according to workload demands, thus optimizing system performance and resource use.

The system 300 controller or memory allocation circuit 312 continuously assesses operational demands and risks, dynamically redistributing tasks between safety and processing islands to enhance performance and fortify the system's resilience.

The system also incorporates a safety tag circuit 310 coupled to the network bus 304 and responsible for identifying computational tiles and islands that are within the safety scope of the system. This circuit 310 assesses each component's function and operational status to ensure that critical functions are contained within safety islands. It also discerns between single and multiple modalities of neural network execution, allowing for precise task distribution and bolstering system robustness.

Beyond in-memory computing tiles, the system's architecture integrates additional critical components 314, such as data movers and scalar operators. Data movers are crucial for the efficient transfer of data between system components, ensuring high throughput and coherence. Scalar operators complement the in-memory computing tiles by performing necessary scalar operations that are not suited for parallel in-memory processing. These components are integrated within the in-memory computing data pipeline, ensuring a cohesive processing flow and highlighting the system's all-encompassing approach to computing tasks. The data movers and scalar operators chained with IMC tiles inherit the safety or processing tagging of original tile.

Although the network bus 304 and tile bus 306 are each illustrated as a single bus, it will be understood that each bus may actually be implemented by several different buses including, for example, data input/output buses, address buses, signaling and control buses, feature data buses, decision data buses, etc. Indeed, different addressing may be utilized dependent on whether the processing tile 302 is configured, through the control signal IMC, as a safety island or a processing island. The addressing when configured as a safety island is decoded by each system 200 to make word line selections and column MUX decoding selections in connection with executing a memory access (read-write) operation. The addressing when configured as a processing island is decoded by each system to make one word line selection per sub-array in connection with the application of the feature data for an in-memory computation operation.

United States Patent Application Publication No. 2024/0071439 is incorporated herein by reference.

The foregoing description has provided by way of exemplary and non-limiting examples a full and informative description of the exemplary embodiment of this invention. However, various modifications and adaptations may become apparent to those skilled in the relevant arts in view of the foregoing description, when read in conjunction with the accompanying drawings and the appended claims. However, all such and similar modifications of the teachings of this invention will still fall within the scope of this invention as defined in the appended claims.

## Claims

1. A circuit, comprising:
a memory array including a plurality of sub-arrays, wherein each sub-array includes memory cells arranged in a matrix with plural rows and plural columns, each row including a word line connected to the memory cells of the row, and each column including a local bit line connected to the memory cells of the column;
a word line drive circuit for each row having an output connected to drive the word line of the row;
a row decoder circuit coupled to the word line drive circuits;
a control circuit configured to support plural modes of memory circuit operation including: a first mode where the row decoder circuit actuates only one word line in the memory array during a memory access operation and a second mode where the row decoder circuit simultaneously actuates one word line per sub-array during an in-memory computation operation;
an input/output circuit for each column comprising:
a plurality of bit line inputs coupled to the local bit lines of the sub-arrays;
a column data output coupled to the plurality of bit line inputs and configured to generate a column data bit for output in the first mode; and
a plurality of sub-array data outputs, where each sub-array data output is coupled to a corresponding one of the plurality of bit line inputs, and configured to generate a plurality of sub-array data bits for output in the second mode;
a column read multiplexing circuit coupled to the column data outputs of the input/output circuits for a first set of columns of the memory array to output data bits in the first mode for a first data word and coupled to the column data outputs of the input/output circuits for a second set of columns of the memory array to output data bits in the first mode for a second data word; and
a processing circuit configured to receive feature data and perform a computational operation in the second mode as a function of the feature data and the plurality of sub-array data bits.

2. The circuit of claim 1, wherein each memory cell is a static random access memory (SRAM) cell.

3. The circuit of claim 2, wherein the SRAM cell is an 8T-type cell, wherein the word line is a read word line of the 8T-type cell and the local bit line is a read bit line of the 8T-type cell.

4. The circuit of claim 2, wherein the SRAM cell is a 6T-type cell, wherein the word line is a word line of the 6T-type cell and the local bit line is one bit line of a complementary pair of bit lines for the 6T-type cell.

5. The circuit of claim 1, wherein each memory cell is a non-volatile memory cell with a deterministic output.

6. The circuit of claim 1, wherein the column read multiplexing circuit comprises:
a first multiplexer having a first input coupled to the column data output of a first input/output circuit coupled to a column in said first set of columns of the memory array and a second input coupled to the column data output of a second input/output circuit coupled to a column in said second set of columns of the memory array;
wherein a selection input of the first multiplexer is configured to receive a multiplexer control signal configured to select one of the first and second inputs for output depending on an address for a read operation in the first mode.

7. The circuit of claim 6, further comprising a gating circuit configured to gate data output from the first multiplexer in response to a sense clock signal.

8. The circuit of claim 7, wherein the gating circuit senses data of the select one of the first and second inputs for output at an output node, and wherein said output node is selectively placed in a tristated condition during the memory access operation.

9. The circuit of claim 6, further comprising a latch circuit configured to latch a data output of the gating circuit, where a clock of said latch circuit is selectively gated in response to the modes of memory circuit operation.

10. The circuit of claim 6, further comprising:
a second multiplexer having a first input coupled to the output of the first multiplexer, an output coupled to a latch circuit and a buffer circuit, and a second input coupled to the output of the second multiplexer;
wherein a selection input of the second multiplexer is configured to receive a mode control signal, the second multiplexer selecting the first input when the mode control signal is in a first state corresponding to the first mode and selecting the second input when the mode control signal is in a second state corresponding to the second mode.

11. The circuit of claim 1, further including an error correction code memory array configured to store error correction code data for the first and second data words.

12. The circuit of claim 11, wherein the error correction code memory array and the memory array are shared same physical memory.

13. A system, comprising:
a plurality of processing tiles interconnected by a network bus;
wherein each processing tile comprises one or more instances of the circuit of claim 1; and
wherein each processing tile is selectively configurable as a safety island when the one or more instances of the circuit of claim 1 are set to operate in the first mode during the memory access operation and as a processing island when the one or more instances of the circuit of claim 1 are set to operate in the second mode during the in-memory computation operation.

14. The system of claim 13, further comprising:
a safety tag circuit coupled to the network bus, said safety tag circuit configured to identify processing tiles allocated as safety islands and ensure critical functions are contained within the safety islands; and
a memory allocation circuit coupled to the network bus, said memory allocation circuit configured to control task distribution between the safety island and processing island.

15. The system of claim 13, wherein the one or more instances of the circuit of claim 1 in each processing tile are coupled by a tile bus which is coupled to the network bus.

16. A circuit, comprising:
a memory array including memory cells arranged in a matrix with plural rows and plural columns;
wherein the memory array stores at least a first data word and a second data word in each row in connection with a memory access mode of operation and stores computational weight data in each row in connection with an in-memory computation mode of operation;
a word line drive circuit for each row having an output connected to drive the word line of the row;
a row decoder circuit coupled to the word line drive circuits;
a control circuit is configured, in the memory access mode of operation, to actuate only one word line in the memory array, and is configured, in the in-memory computation mode of operation, to simultaneously actuate plural word lines in the memory array;
an input/output circuit for each column comprising:
a first read circuit configured to read a data bit from the memory cell of the column accessed in response to actuation of the only one word line in the memory array; and
a second read circuit configured to read plural data bits from the memory cells of the column accessed in response to simultaneous actuation of the plural word lines in the memory array;
a column read multiplexing circuit coupled to the input/output circuits for a first set of columns of the memory array to output the read data bits of the first data word accessed in response to actuation of the only one word line in the memory array and coupled to the input/output circuits for a second set of columns of the memory array to output the read data bits of the second data word accessed in response to actuation of the only one word line in the memory array; and
a processing circuit configured to receive feature data and perform a computational operation in the in-memory computation mode of operation as a function of the feature data and the read plural data bits from the memory cells of the column accessed in response to simultaneous actuation of the plural word lines in the memory array.

17. The circuit of claim 16, further including an error correction code memory array configured to store error correction code data for the first and second data words.

18. The circuit of claim 17, wherein the error correction code memory array and the memory array are shared same physical memory.

19. The circuit of claim 16, wherein each memory cell is a static random access memory (SRAM) cell.

20. The circuit of claim 16, wherein each memory cell is a memory cell with a deterministic output.

21. The circuit of claim 16, wherein the column read multiplexing circuit comprises:
a first multiplexer having a first input coupled to receive one read data bit of the first data word accessed in response to actuation of the only one word line in the memory array and a second input coupled to receive one read data bit of the second data word accessed in response to actuation of the only one word line in the memory array;
wherein a selection input of the first multiplexer is configured to receive a multiplexer control signal configured to select one of the first and second inputs for output depending on an address for a read operation in the memory access mode of operation.

22. The circuit of claim 21, further comprising a gating circuit configured to gate data output from the first multiplexer in response to a sense clock signal.

23. The circuit of claim 22, wherein the gating circuit senses data of the select one of the first and second inputs for output at an output node, and wherein said output node is selectively placed in a tristated condition during the memory access operation.

24. The circuit of claim 23, further comprising a latch circuit configured to latch a data output of the gating circuit, where a clock of said latch circuit is selectively applied during the in-memory computation mode of operation.

25. The circuit of claim 21, further comprising:
a second multiplexer having a first input coupled to the output of the first multiplexer, an output coupled to a latch circuit and a buffer circuit, and a second input coupled to the output of the second multiplexer;
wherein a selection input of the second multiplexer is configured to receive a mode control signal, the second multiplexer selecting the first input when the mode control signal is in a first state corresponding to the first mode and selecting the second input when the mode control signal is in a second state corresponding to the second mode.

26. A system, comprising:
a plurality of processing tiles interconnected by a network bus;
wherein each processing tile comprises one or more instances of the circuit of claim 16; and
wherein each processing tile is selectively configurable as a safety island when the one or more instances of the circuit of claim 16 are set to operate in the memory access mode of operation and as a processing island when the one or more instances of the circuit of claim 16 are set to operate in the in-memory computation mode of operation.

27. The system of claim 26, further comprising:
a safety tag circuit coupled to the network bus, said safety tag circuit configured to identify processing tiles allocated as safety islands and ensure critical functions are contained within the safety islands; and
a memory allocation circuit coupled to the network bus, said memory allocation circuit configured to control task distribution between the safety island and processing island.

28. The system of claim 26, wherein the one or more instances of the circuit of claim 16 in each processing tile are coupled by a tile bus which is coupled to the network bus.
